Europäisches Patentamt

European Patent Office

Office européen des brevets

(11) Numéro de publication : **0 176 671**
**B1**

(12) **FASCICULE DE BREVET EUROPÉEN**

(45) Date de publication du fascicule du brevet :
26.04.89

(51) Int. Cl.⁴ : **H 01 L 35/08**, H 01 L 35/30,
H 01 L 35/32

(21) Numéro de dépôt : **85108414.5**

(22) Date de dépôt : **06.07.85**

(54) Perfectionnements apportés aux modules thermo-électriques à plusieurs thermo-éléments pour installation thermo-électrique, et installation thermo-électrique comportant de teis modules thermo-électriques.

(30) Priorité : **12.09.84 FR 8413990**

(43) Date de publication de la demande :
**09.04.86 Bulletin 86/15**

(45) Mention de la délivrance du brevet :
**26.04.89 Bulletin 89/17**

(84) Etats contractants désignés :
**CH DE GB IT LI NL SE**

(56) Documents cités :
**FR--A-- 2 309 984**
**FR--A-- 2 322 459**
**GB--A-- 930 580**
**GB--A-- 1 046 427**
**US--A-- 3 291 648**

(73) Titulaire : **TUNZINI NESSI ENTREPRISES D'EQUIPE-MENTS**
**250, Route de l'Empereur**
**F-92508 Rueil Malmaison (FR)**

(72) Inventeur : **Schlicklin, Philippe**
**21 rue du Maréchal Gérard**
**F-54000 Nancy (FR)**
Inventeur : **Stockholm, John G.**
**11 rue de Bellan**
**F-78540 Vernouillet (FR)**

(74) Mandataire : **Puit, Thierry et al**
**Centre de Recherches de Pont-à-Mousson Service de Propriété Industrielle Boîte Postale 109**
**F-54704 Pont-à-Mousson Cédex (FR)**

## Description

La présente invention concerne des modules thermo-électriques à plusieurs thermo-éléments, ainsi que des installations thermo-électriques, utilisables aussi bien dans une pompe à chaleur que dans un générateur d'électricité, comportant de tels modules thermo-électriques.

L'effet thermo-électrique est utilisé dans le mode de fonctionnement en pompe à chaleur pour faire transiter de l'énergie thermique d'une source froide vers une source chaude grâce à l'énergie électrique fournie à des thermo-éléments fabriqués en un matériau thermo-électrique. Dans le mode de fonctionnement en génération d'électricité, le passage de l'énergie thermique fournie par une source chaude vers une source froide au travers de thermo-éléments permet de recueillir aux bornes de ceux-ci de l'énergie électrique.

Dans les deux cas, les thermo-éléments associés aux moyens d'échange de chaleur peuvent être mis en œuvre selon deux modalités.

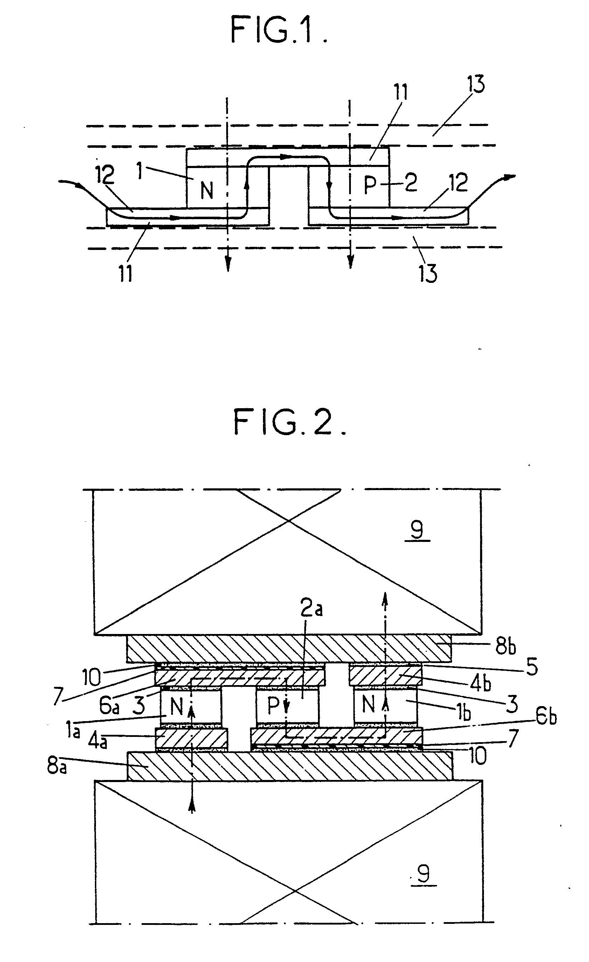

Selon un premier mode de mise en œuvre, on peut utiliser des modules thermo-électriques de type connu qui sont constitués d'une pluralité de thermo-éléments rassemblant un nombre entier de couples thermo-électriques (un élément de type N et un élément de type P) assemblés dans une structure qui les place électriquement en série et thermiquement en parallèle. La figure 1 présente le principe du montage des thermo-éléments. Dans cette figure, le nombre des thermo-éléments est réduit à deux, soit un couple avec un thermo-élément 1 de type N et un thermo-élément 2 de type P reliés électriquement par des conducteurs électriques brasés sur les faces des thermo-éléments. On peut distinguer deux types de conducteurs électriques, les conducteurs 11 qui relient les faces de deux thermo-éléments en série et les conducteurs 12 qui servent d'entrée et de sortie du courant électrique dans le module. Pour assurer la continuité électrique du circuit, il est nécessaire d'isoler électriquement les conducteurs électriques reliant les thermo-éléments des échangeurs de chaleur associés. En général, cet isolement est obtenu par des plaquettes en céramique 13 en contact intime avec les conducteurs électriques. Ces plaquettes introduisent une résistance thermique importante entre les thermo-éléments et les échangeurs et abaissent ainsi le rendement thermique des modules. De plus, les plaquettes de céramique sont fragiles, leur montage doit être effectué avec précaution et on ne peut leur appliquer que des pressions de contact faibles, inférieures à 1 MPa, créant ainsi des résistances thermiques de contact importantes.

Enfin, la rigidité diélectrique des plaquettes de céramique est assez faible et l'utilisation des modules sous des tensions élevées n'est pas possible car il se produit des claquages par cheminement de décharges électriques créant des défauts d'isolement.

Pour s'affranchir de ces inconvénients, on a recours à un second mode de mise en œuvre des thermo-éléments associés aux échangeurs. Selon ce mode de mise en œuvre, les échangeurs de chaleur servent eux-mêmes à conduire le courant électrique. On supprime de la sorte les résistances thermiques créés par les moyens d'isolement.

On connait ainsi par le brevet GB-A-930 580 un dispositif thermo-électrique dans lequel des thermo-éléments sont directement soudés à des ailettes constituant des échangeurs de chaleur. Le courant électrique circule d'un thermo-élément à l'autre par les ailettes. Les thermo-éléments et les ailettes associées sont enrobés dans un matériau isolant thermique et électrique.

On connait encore par le brevet FR A-2 322 459 un autre dispositif thermo-électrique constitué de thermo-élément placés en contact thermique et électrique avec des échangeurs de chaleur. Chaque thermo-élément est fixé, d'une part sur un premier échangeur, et d'autre part est en contact avec un second échangeur par l'intermédiaire d'une pièce métallique se terminant par une calotte sphérique qui coopère avec une empreinte de forme complémentaire ménagée dans ce second échangeur. Le courant électrique circule d'un thermo-élément à l'autre par les échangeurs.

L'intégration des thermo-éléments aux échangeurs oblige à proportionner les premiers aux seconds, ce qui signifie qu'il faut leur donner une section suffisante pour assurer une puissance thermique convenable pour une utilisation optimum des échangeurs. Une section importante implique le passage d'un courant électrique d'intensité élevée au travers des thermo-éléments et corrélativement d'une tension faible. En effet, pour obtenir une puissance thermique déterminée dans le cas de l'utilisation en pompe à chaleur, ou pour obtenir une puissance électrique générée à partir d'une puissance thermique déterminée dans le cas de l'utilisation en générateur d'électricité, il faut un nombre plus petit de thermo-éléments intégrés de forte section que le nombre de thermo-éléments élémentaires de plus faible section constituant les modules utilisés dans le premier mode de mise en œuvre présenté ci-dessus.

En effet, la puissance thermique pompée, ou la puissance électrique générée, étant proportionnelle à la surface des thermo-éléments utilisés, pour un même résultat, la somme des sections des thermo-éléments d'un module thermo-électrique est équivalente à la section du thermo-élément intégré directement aux échangeurs.

Dans le cas de l'utilisation en pompe à chaleur, il faut donc prévoir une alimentation électrique, en courant continu, délivrant une forte intensité sous une faible tension, ce qui implique un dispositif d'alimentation électrique lourd et volumineux ; dans le cas de la génération d'électricité, le courant est recueilli sous une faible tension et une intensité relativement grande, ce qui convient mal à la plupart des utilisations de cette énergie.

A titre d'exemple, une batterie thermo-électrique comprenant 480 thermo-éléments de section unitaire 1,5 cm² intégrés à des échangeurs fonctionne en pompe à chaleur pour des conditions déterminées sous une tension de 13 volts avec un courant de 200 ampères, et en génération d'électricité pour les mêmes conditions thermiques, cette même batterie délivre 30 ampères sous 3,5 volts.

La présente invention a pour but de créer un module thermo-électrique qui associe l'efficacité thermique et la bonne tenue mécanique des thermo-éléments intégrés à la possibilité d'utilisation d'un courant électrique de tension relativement élevée et d'intensité relativement faible. Les installations thermo-électriques utilisant ces modules nouveaux sont du type où les échangeurs de chaleur assurent la transmission du courant électrique.

Le module thermo-électrique selon l'invention telle que revendique un nombre impair de thermo-éléments mis en série électriquement par des conducteurs de courant dont la face opposée aux thermo-éléments est isolée électriquement des pièces métalliques en contact thermique et électrique avec les échangeurs de chaleur qui constituent la structure extérieure du module, le courant électrique parcourant les échangeurs étant amené dans le module par lesdites pièces métalliques, chacune d'entre elles étant en contact électrique avec leur conducteur particulier ou spécial lui-même lié à la face d'entrée ou de sortie du courant du thermo-élément d'entrée ou de sortie de ce courant.

Les caractéristiques et avantages de l'invention apparaîtront dans la description qui va suivre, description qui s'appuie sur les dessins annexés donnés à titre d'exemple :

— la fig. 1 représente le schéma de montage des thermo-éléments tel qu'il est utilisé dans les modules thermo-électriques connus ;

— la fig. 2 est une coupe en élévation montrant le principe d'un module thermo-électrique selon l'invention, placé entre deux échangeurs de chaleur ;

— la fig. 3 est une vue schématique en perspective d'un module thermo-électrique selon l'invention, comportant trois thermo-éléments, dont la section est une portion de disque, la partie supérieure du module étant représentée soulevée pour des raisons de clarté.

— la fig. 4 est une vue schématique en perspective d'un module thermo-électrique selon l'invention analogue à la fig. 3 mais comportant sept thermo-éléments de section circulaire ;

— la fig. 5 représente la vue en plan d'une variante de réalisation d'un module thermo-électrique selon l'invention, de forme rectangulaire, comportant onze thermo-éléments de section carrée, cette figure donnant le schéma des liaisons électriques du côté inférieur ;

— la fig. 6 qui est une vue rabattue sur la droite du côté supérieur du module de la fig. 5, montre le schéma des liaisons électriques supérieures ;

— les fig. 7 et 8 donnent respectivement le schéma de deux empilements d'échangeur de chaleur et de modules thermo-électriques selon l'invention, ces derniers étant semblables à celui représenté par la fig. 2 ;

— la fig. 9 montre un module selon l'invention dont l'une des faces extérieures venant en contact avec un échangeur de chaleur est une surface sphérique convexe, l'autre face étant plane ;

— la fig. 10 représente un module thermo-électrique selon l'invention dont les deux faces venant en contact avec les échangeurs de chaleur sont des surfaces cylindriques convexes d'axes parallèles ;

— la fig. 11 représente un module selon l'invention où l'une des faces en contact avec l'échangeur thermique est une surface cylindrique concave, l'autre face étant plane.

Suivant le schéma de principe représenté par la fig. 2, un module thermo-électrique selon l'invention comporte un nombre impair d'éléments thermo-électriques alternativement de type N (référence 1a, 1b) et de type P (référence 2a) reliés par des moyens de connexion tels que des brasures 3 à des conducteurs électriques destinés à les placer en série, ces conducteurs pouvant être soit en bon contact électrique et thermique avec des pièces 8a, 8b en contact avec les échangeurs thermiques 9 soit isolés électriquement mais en bon contact thermique avec les pièces 8a, 8b.

Un premier type de conducteur 4a, 4b assure la liaison électrique entre les pièces 8a, 8b en contact avec les échangeurs de chaleur 9 et les faces d'entrée ou de sortie des thermo-éléments 1a et 1b constituant l'entrée et la sortie du courant dans le module. Il y a donc deux conducteurs 4a, 4b pour le module, chacun d'eux étant lié à une des pièces 8a, 8b par une brasure 5, de sorte que l'entrée du courant se fait par l'une des pièces 8a, 8b et la sortie par la pièce 8b, 8a opposée.

Un second type de conducteur 6a, 6b assure la liaison électrique entre les éléments thermo-électriques 1a, 1b et 2a pris deux à deux, le courant électrique ne pouvant transiter par les pièces 8a, 8b, grâce à une couche isolante électrique 7 placée sur la face des conducteurs 6a, 6b en regard de ces pièces 8a, 8b. Pour assurer un bon contact thermique et une solidarisation mécanique des conducteurs 6a, 6b avec les pièces 8a, 8b, on utilise une couche 10, qui peut être de même nature que la couche isolante 7 si celle-ci est un composé électriquement isolant et thermiquement conducteur pouvant jouer le rôle d'adhésif pour les surfaces des pièces en regard 6a, 6b et 8a, 8b ou une couche d'un autre composé telle une brasure qui nécessite alors un traitement de surface approprié de la face extérieure de la couche isolante 7 pour permettre l'accrochage de la brasure sur cette face.

Le montage représenté par la fig. 2, qui ne comporte que trois thermo-éléments pour des raisons de simplicité du dessin, utilise un module selon l'invention à deux thermo-éléments 1a, 1b de type N et un seul thermo-élément 2a de type P. Ce module est fonctionnellement équivalent à un module particulier qui utiliserait un seul thermo-élément de type N dont la section serait égale à la somme des sections des trois thermo-éléments du module, dans la mesure où l'on admet que les performances des deux types de matériaux sont égale. Mais ce thermo-élément unique nécessiterait le passage d'un courant électrique d'une intensité triple et d'une tension égale au tiers de celles que requièrent le module selon l'invention.

Dans le cas où les deux types de matériaux sont équivalents, on peut donner aux deux types d'éléments N et P la même section. Dans la pratique cette solution est la plus simple, mais on ne s'écarte pas du cadre de la présente invention en donnant à chacun des types N et P une section adaptée pour optimiser le couple N + P, par exemple pour le courant nominal prévu pour la batterie.

On voit donc que l'on peut utiliser pour la réalisation d'installations thermo-électriques des modules selon l'invention des deux types N et P exactement comme on utilise des thermo-éléments uniques intégrés à des échangeurs de chaleur, avec l'avantage de pouvoir diviser l'intensité électrique et multiplier la tension par (2x+1), c'est-à-dire par le nombre de thermo-éléments utilisés dans la confection des modules.

En résumé, un module thermo-électrique selon l'invention comprend :

. (2x+1) thermo-éléments répartis en
.. (x+1) d'un type N ou P
.. x de l'autre type P ou N
. 2x conducteurs électriques 6a, 6b isolés électriquement par la couche 7,10 des pièces 8a, 8b et reliant les thermo-éléments deux à deux à l'intérieur du module.
. 2 conducteurs électriques 4a, 4b en bon contact électrique avec les pièces 8a, 8b et assurant l'entrée et la sortie du courant pour le module (les deux thermo-éléments d'entrée et de sortie en contact avec un conducteur 4a ou 4b étant obligatoirement du même type que celui des (x+1) thermo-éléments).
. 2 pièces 8a, 8b conductrices de la chaleur et de l'électricité en bon contact thermique et électrique sur leur face interne, chacune avec un conducteur 4a ou 4b et en bon contact thermique seulement avec x conducteurs 6a, 6b qui en sont isolés électriquement par la couche 7 et solidarisés par la couche 10.

Comme montré sur la fig. 2, pour construire un module selon l'invention, on peut tout d'abord réaliser les liaisons entre les pièces 8a, 8b et les conducteurs électriques 4a, 4b et 6a, 6b. Les conducteurs 4a, 4b sont brasés sur les pièces 8a, 8b à l'aide d'une brasure 5 et les conducteurs 6a, 6b sont liés à ces pièces 8a, 8b par une couche 10 adhérant à la fois à la pièce 8a, 8b considérée et à la couche isolante électrique 7 déposée à la surface des conducteurs 6a, 6b en regard de la pièce 8a, 8b correspondante. Un même produit peut à la fois assurer les fonctions des deux couches 7 et 10 qui ont été différenciées fonctionnellement.

Les pièces 8a, 8b portant les connexions électriques 4a, 4b et 6a, 6b reçoivent éventuellement une barrière de diffusion, par exemple une couche de nickel, pour éviter une contamination des thermo-éléments par diffusion des constituants des conducteurs électriques, par exemple le cuivre, dans la brasure 3, lors de l'opération de brasure des thermo-éléments sur les conducteurs qui constitue la dernière phase du montage du module selon l'invention avant le façonnage des deux surfaces de contact extérieures.

Dans ce cas, le point de fusion de la brasure 3 utilisée pour lier les thermo-éléments sur les conducteurs doit être inférieur à celui de la brasure 5 et éventuellement de la brasure 10 pour ne pas débraser l'ensemble déjà réalisé.

Dans un autre mode de réalisation d'un module selon l'invention, on peut réaliser en premier le brasage des thermo-éléments à l'aide de la brasure 3 sur les conducteurs 4a, 4b et 6a, 6b possédant déjà leur barrière de diffusion si nécessaire et pour les conducteurs 6a, 6b la couche isolante électrique 7 si celle-ci est distincte de la couche d'accrochage 10. Le montage peut se faire dans un gabarit adapté et la partie centrale du module selon l'invention ainsi monté est assemblée entre les deux pièces 8a, 8b à l'aide de la brasure 5 pour les conducteurs 4a, 4b et de la couche adhésive 10 pour les conducteurs 6a, 6b, cette couche 10 pouvant être une brasure éventuellement identique à la brasure 5 ou un adhésif éventuellement identique à la couche isolante 7. Dans ce mode de réalisation, le point de fusion de la brasure 5 et éventuellement 10 doit être inférieur à celui de la brasure 3 qui lie les thermo-éléments aux conducteurs pour ne pas débraser les liaisons déjà réalisées.

Il est à noter que la couche isolante 7 interposée entre les conducteurs 6a, 6b, et les pièces 8a, 8b peut éventuellement présenter une rigidité diélectrique assez faible, puisque la différence de potentiel qu'elle aura à supporter est au plus de quelques volts correspondant à la tension de fonctionnement du module. Un léger défaut d'isolement entre un conducteur 6a, 6b et la pièce 8a, 8b correspondante se traduira par un courant de fuite très faible dont l'effet thermique perturbant le fonctionnement thermique du module peut être considéré comme négligeable.

Ces modules thermo-électriques selon l'invention sont substituables simplement aux éléments thermo-électriques uniques utilisés dans la réalisation d'installations à thermo-éléments intégrés. Les modules selon l'invention ont alors des formes semblables et des dimensions comparables à celles des éléments qu'ils remplacent.

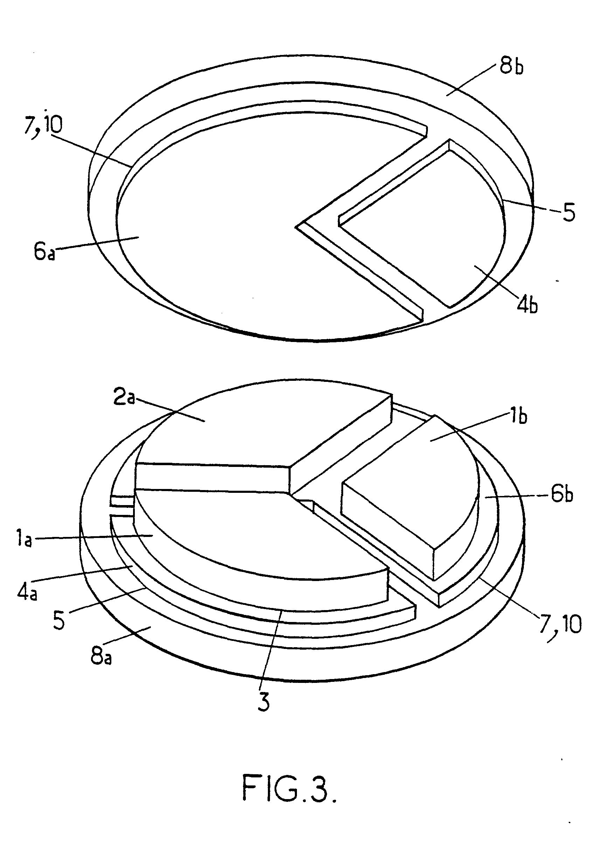

Les pièces 8a, 8b qui sont en contact thermique et électrique avec les échangeurs de chaleur par leurs faces non visibles sur la figure 3 sont réalisées en métal bon conducteur de la chaleur et de l'électricité, par exemple en cuivre ou en aluminium ayant subi un traitement de surface pour réduire les résistances thermique et électrique de surface et permettre la brasure éventuelle des deux conducteurs 4a, 4b.

Ces pièces 8a, 8b portent chacune, dans ce cas, un conducteur 4a, 4b solidarisé à la pièce 8a, 8b correspondante par la brasure 5 et un conducteur 6a, 6b isolé électriquement par la couche 7 et solidarisé à la pièce 8a, 8b correspondante par la couche 10. Ces deux types de conducteurs ont la forme de portions de disque embrassant environ un tiers de surface pour le conducteur 4a, 4b et deux tiers de circonférence pour le conducteur 6a, 6b et sont fixés sur les pièces 8a, 8b de façon non jointive pour ne pas les mettre en contact électrique l'un avec l'autre.

Les éléments thermo-électriques 1a, 1b et 2a ont la forme de portion de disque (approximativement un tiers de disque) et obtenus par exemple par découpe appropriée de tranches de lingots de matériaux thermo-électriques de section circulaire. Ces éléments sont solidarisés aux conducteurs 4a, 4b et 6a, 6b par une brasure 3, les conducteurs étant munis éventuellement sur leur face en contact avec les thermo-éléments d'une barrière de diffusion empêchant la contamination des matériaux thermo-électriques par le métal des conducteurs 4a, 4b et 6a, 6b. Cette barrière de diffusion est classiquement une couche de nickel.

Les liaisons électriques de la partie supérieure sont identiques à celles de la partie inférieure à une rotation près qui permet de décaler de 120° les conducteurs 4a, 4b qui assurent l'entrée et la sortie du courant dans le module. Dans le cas de la figure 3, l'entrée et la sortie se font par un thermo-élément 1a et 1b du type N et le module selon l'invention est donc fonctionnellement équivalent à un thermo-élément de type N.

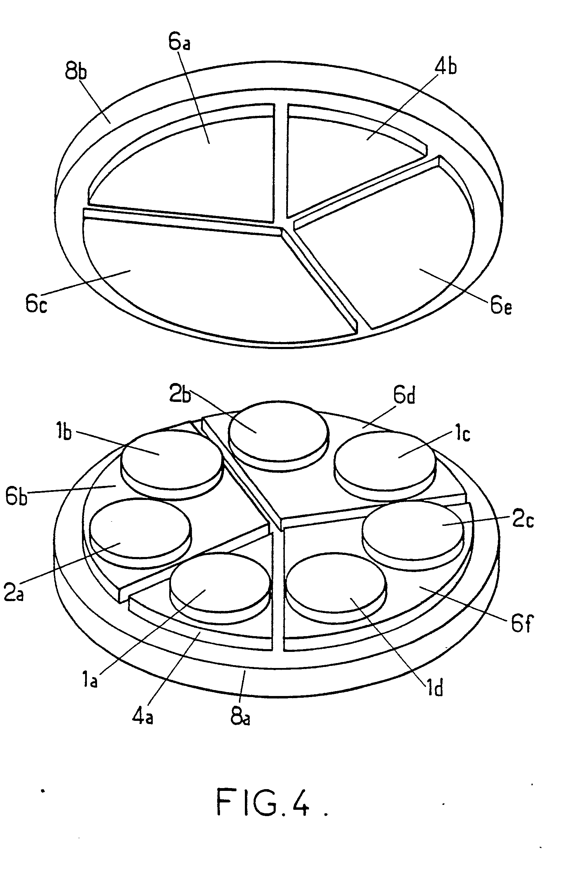

La figure 4, comparable à la figure 3, donne un autre exemple de réalisation d'un module selon l'invention ; comme pour la figure 3, ce module est de plan circulaire mais il comporte sept thermo-éléments de section circulaire.

Dans cette figure, si l'on suppose que le courant électrique entre par la pièce inférieure 8a, il traversera successivement le conducteur 4a, le thermo-élément de type N 1a, le conducteur 6a situé sur la pièce supérieure 8b, le thermo-élément de type P 2a, le conducteur 6b situé sur la pièce 8a, le thermo-élément N 1b, le conducteur 6c, le thermo-élément P 2b, le conducteur 6d, le thermo-élément N 1c, le conducteur 6e, le thermo-élément P 2c, le conducteur 6 f, le thermo-élément N 1d, le conducteur 4b et sortira par la pièce supérieure 8b.

Dans cet exemple, comme dans celui de la fig. 3, l'entrée et la sortie du courant se font par un thermo-élément de type N et le module selon l'invention est fonctionnellement équivalent à un thermo-élément unique de type N.

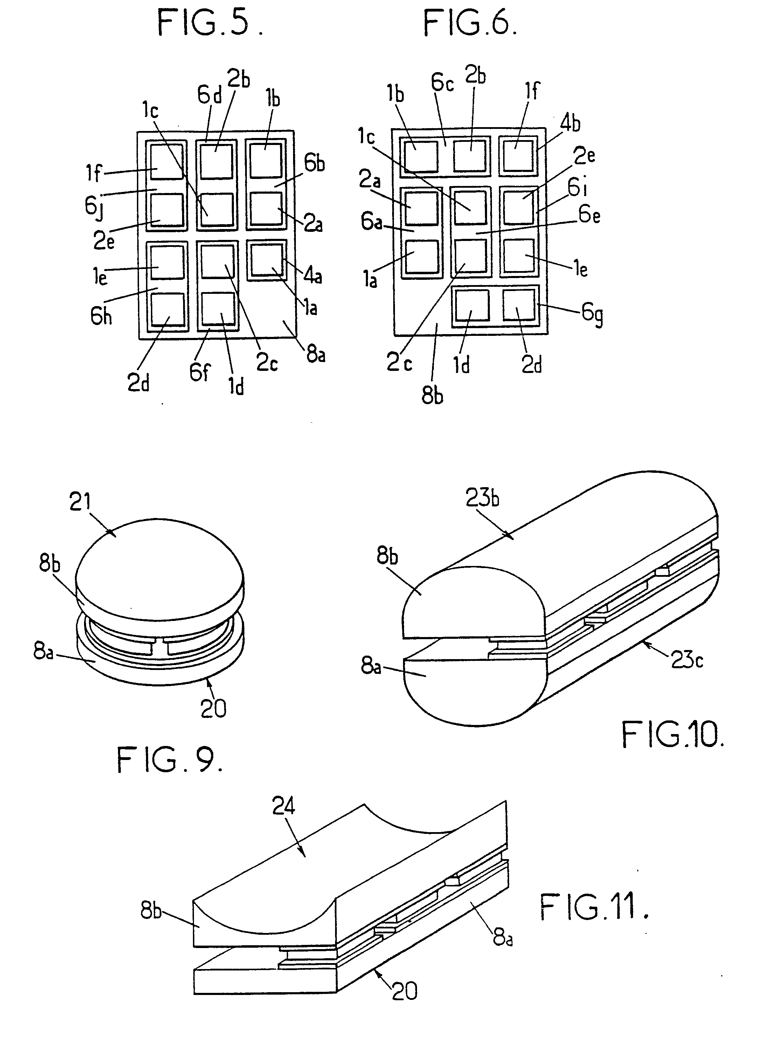

Une autre variante de forme de réalisation de module selon l'invention est représentée dans les fig. 5 et 6.

Ce module est de plan rectangulaire et comporte onze thermo-éléments répartis en trois rangées dont l'une est incomplète.

La figure 5 est une vue en plan de la partie inférieure du module montrant les liaisons électriques.

L'entrée du courant se fait par la pièce 8a de forme rectangulaire en bon contact thermique et électrique avec un échangeur de chaleur servant également de conducteur électrique. Le courant entre dans la série des onze thermo-éléments 1a, 2a, 1b, 2b, 1c, 2c, 1d, 2d, 1e, 2e et 1f par le conducteur 4a en bon contact électrique avec la pièce 8a, les conducteurs 6b, 6d, 6f, 6h, 6j étant isolés électriquement de la plaque 8a mais en bon contact thermique avec celle-ci.

La figure 6 où les mêmes numéros de repère désignent les mêmes pièces est une vue en plan de la partie supérieure du module de la figure 5 supposée rabattue vers la droite, montrant comme la figure précédente les liaisons électriques et la trace des thermo-éléments.

Le courant parcourt successivement, entre la pièce 8a et la pièce 8b, le conducteur 4a, le thermo-élément 1a, le conducteur 6a, le thermo-élément 2a, le conducteur 6b, le thermo-élément 1b, le conducteur 6c, le thermo-élément 2b, le conducteur 6d, le thermo-élément 1c, le conducteur 6e, le thermo-élément 2c, le conducteur 6f, le thermo-élément 1d, le conducteur 6g, le thermo-élément 2d, le conducteur 6h, le thermo-élément 1e, le conducteur 6i, le thermo-élément 2e, le conducteur 6j, le thermo-élément 1f, et le conducteur 4b.

Comme dans les deux exemples précédents, l'entrée et la sortie du courant se faisant par deux thermo-éléments de type N, le module à onze thermo-éléments selon l'invention est fonctionnellement équivalent à un thermo-élément unique de type N.

Une telle disposition est comparable géométriquement à celle adoptée pour la réalisation des modules thermo-électriques classiques, mais dans la présente invention deux plaques conductrices 8a et 8b remplacent les plaques isolantes que l'on trouve dans le montage classique et il y a un nombre impair de thermo-éléments, alors que ce nombre est pair dans les modules classiques.

Bien entendu, on ne s'écarte pas de l'esprit de l'invention en réalisant des modules de forme rectangulaire à une seule rangée de thermo-éléments, de forme carrée ou polygonale régulière ou non.

Une variante de réalisation consiste à obtenir, par exemple par usinage ou estampage, une pièce unique réunissant la pièce 8a, 8b et le conducteur 4a, 4b qui lui est associé.

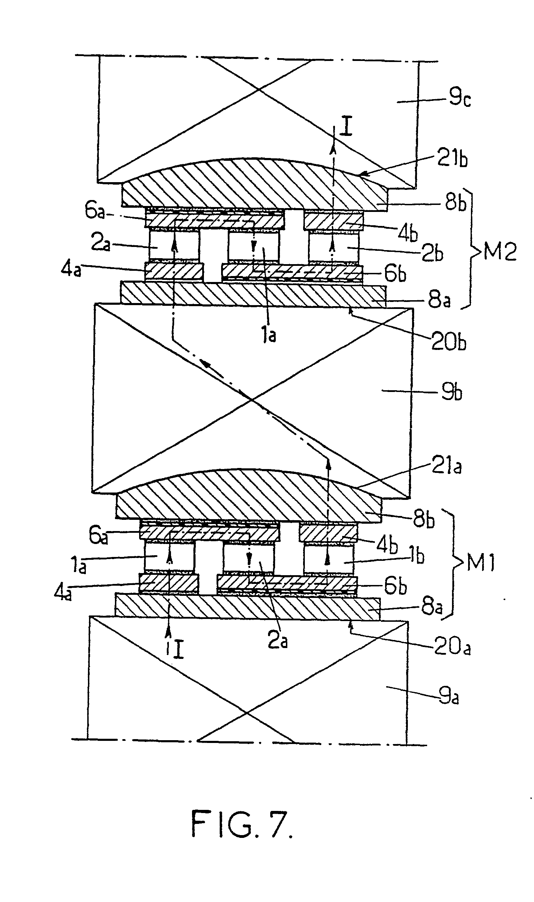

L'utilisation des modules selon l'invention se fait en réalisant des installations thermo-électriques compactes dont le motif de base est l'empilement d'une pièce active, c'est-à-dire le module selon l'invention serré entre un échangeur froid (parcouru par le fluide à refroidir) et un échangeur chaud (parcouru par le fluide à réchauffer). Un tel empilement est montré dans la fig. 7 qui représente un ensemble comprenant trois échangeurs de chaleur 9a, 9b, 9c et deux modules selon l'invention, semblables, pour des raisons de simplicité du dessin, à celui présenté par la fig. 2 (les mêmes chiffres de référence désignant les mêmes organes sur la fig. 7 que sur la fig. 2).

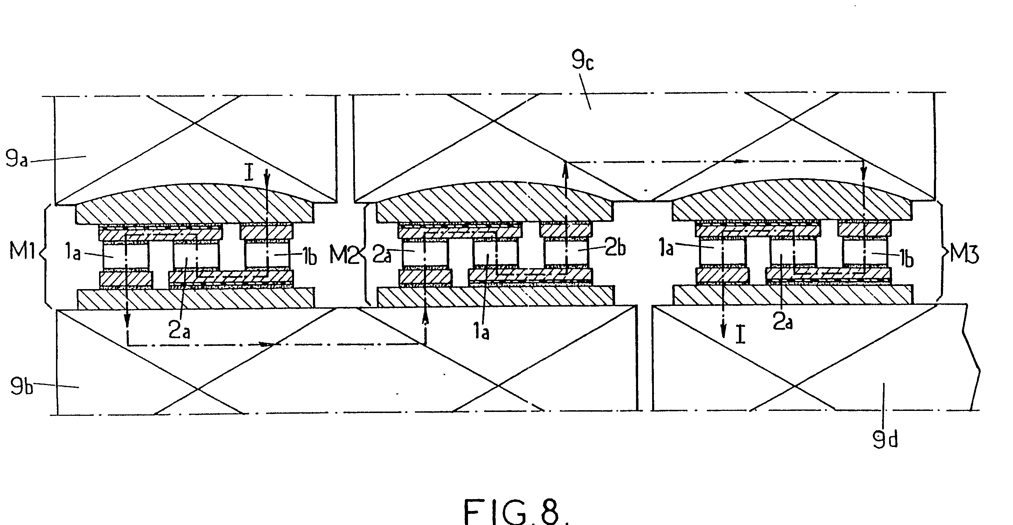

Une variante de cet empilement est également montrée sur la fig. 8 sur laquelle les mêmes chiffres de référence désignent les mêmes organes que sur la fig. 7 : selon cette variante, c'est la disposition relative des divers organes qui est différente de celle de la fig. 7, et la description de la fig. 7 qui suit s'applique à cette fig. 8.

Dans la fig. 7, on voit deux modules selon l'invention, l'un M1 équivalent à un type N, l'autre M2 à un type P coopérant avec trois échangeurs de chaleur 9a, 9b, 9c pour former un empilement en colonne parcouru par le courant électrique de bas en haut.

Le module M1 est en bonne relation thermique et électrique avec les échangeurs de chaleur 9a et 9b par l'intermédiaire des surfaces 20a et 21a qui sont respectivement les faces extérieures des pièces 8a et 8b du module M1. De même, le module M2 est en bonne relation thermique et électrique avec les échangeurs de chaleur 9b et 9c par l'intermédiaire des surfaces 20b et 21b qui sont respectivement les faces extérieures des pièces 8a et 8b du module M2.

Dans la fig. 8, on voit trois modules selon l'invention M1, M2, M3 coopérant avec quatre échangeurs de chaleur 9a, 9b, 9c, 9d pour former un agencement parcouru par le courant électrique suivant un trajet en créneaux.

On voit sur la fig. 7 que chacun des modules selon l'invention coopère avec les échangeurs de chaleur correspondants par une surface plane (20a ou 20b) d'un côté et par une surface non plane (21a ou 21b) qui ici est supposée être une portion de surface sphérique convexe de l'autre côté. Il en est de même sur la fig. 8.

Cette disposition est dictée par les considérations développées ci-après :

Le matériau thermo-électrique présentant une bonne résistance mécanique seulement en compression, il est avantageux de placer l'empilement sous compression. Cette technique permet en outre de réaliser des montages d'installations thermo-électriques comprenant un grand nombre de pièces actives par juxtaposition de pièces non brasées, les pièces actives venant en contact avec les échangeurs de chaleur par des interfaces appropriées. Une fois l'installation assemblée, on peut éventuellement braser toutes ou une partie des interfaces, à condition d'avoir placé sur celle-ci une couche ou une feuille d'une brasure dont la température de fusion soit suffisamment basse pour pouvoir être mise en œuvre par élévation de température de l'ensemble de l'installation sans dommages pour celle-ci. Cependant, dans de nombreux cas, on peut utiliser des contacts non brasés, le montage sous compression de l'installation conduisant à des pressions élevées (10 MPa ou plus) aux interfaces, ce qui assure des résistances thermiques et électriques très faibles pour ces interfaces où l'on peut interposer de plus une pâte conductrice de la chaleur et de l'électricité.

La géométrie des interfaces est dictée non seulement par des considérations thermiques et électriques, mais également par des impératifs d'ordre mécanique. Les très médiocres résistances en traction et cisaillement des matériaux thermo-électriques imposent en pratique un montage des installations thermo-électriques qui laissent dans tous les cas les matériaux thermo-électriques sous compression, leurs propriétés mécaniques étant bonnes seulement en compression.

Il faut appliquer la pression de façon régulière sur les éléments thermo-électriques composant un module selon l'invention, pour ne générer aucune composante de cisaillement ou de torsion qui amènerait une destruction des thermo-éléments ou de leurs liaisons.

Un contact plan entre les pièces 8a, 8b et les échangeurs de chaleurs 9a, 9b, 9c pour chacune des interfaces du module présente des risques dus aux défauts de parallélisme des deux faces du module : le pincement en un point qui en résulte peut mettre en traction et détériorer un autre point du module. C'est d'ailleurs ce danger qui interdit d'utiliser pour les modules thermo-électriques classiques, qui présentent toujours deux interfaces planes, un serrage suffisant pour assurer de bons contacts thermiques.

Il est donc avantageux que l'un au moins des deux contacts du module présente une géométrie particulière qui permette le rattrapage des défauts de parallélisme de toutes les pièces de l'empilage susmentionné (échangeurs et pièces actives) et la transmission des seuls efforts de compression au niveau des thermo-éléments. Ces résultats sont obtenus en adoptant, pour au moins une des faces en contact, une surface sphérique ou cylindrique.

La surface sphérique est particulièrement bien adaptée au cas des modules à section circulaire.

La figure 9 montre un module à plan circulaire selon l'invention dont une surface de contact 20 qui est la face extérieure de la pièce 8a est plane et l'autre, qui est la face extérieure de la pièce 8b, est une portion de surface sphérique convexe 21.

Bien entendu, on peut imaginer toutes les combinaisons possibles : deux surfaces sphériques convexes ou concaves, une surface sphérique concave et une autre convexe ou une surface plane et une surface sphérique concave, qui n'ont pas été représentées ici pour ne pas multiplier le nombre de dessins.

La ou les surfaces sphériques coopèrent avec des surfaces conjuguées ménagées dans les échangeurs de chaleur. Ceux-ci sont munis, soit d'une cuvette si les modules présentent des surfaces sphériques convexes, soit d'une calotte sphérique en saillie si les modules portent des surfaces sphériques concaves. Dans tous les cas, le rayon de la cuvette doit être légèrement supérieur à celui de la surface convexe conjuguée pour permettre un positionnement lors de la mise en place.

On peut également utiliser des contacts constitués par des portions de surfaces cylindriques. Cette forme est plus spécialement mais non exclusivement adaptée aux modules selon l'invention à plan rectangulaire ou carré.

La figure 10 montre un module selon l'invention où les surfaces de contact 23a et 23b, respectivement des pièces 8a, 8b, avec les échangeurs correspondants sont des surfaces cylindriques convexes d'axes parallèles. La figure 11 présente un module selon l'invention avec un contact cylindrique concave 24 (pour la pièce 8b), l'autre contact 20 étant plan (pour la pièce 8a).

On peut imaginer également sans sortir du cadre de l'invention les combinaisons non représentées par des figures du présent brevet :

— un contact plan et un contact cylindrique convexe ou concave,

— deux contacts cylindriques concaves à axes parallèles,

— deux contacts cylindriques convexes ou concaves à axes orthogonaux situés dans des plans parallèles entre eux,

— un contact sphérique et un contact cylindrique avec les combinaisons des formes concaves ou convexes.

La ou les surfaces cylindriques doivent coopérer avec des surfaces cylindriques conjuguées situées sur les échangeurs de chaleur. Ces surfaces peuvent être des rainures ou gouttières cylindriques si les modules portent des surfaces cylindriques convexes ou des surfaces cylindriques en saillie si les surfaces cylindriques des modules sont concaves.

Comme pour les assemblages de surfaces sphériques, le rayon de la portée femelle sera avantageusement légèrement supérieur à celui de la portée mâle.

Comme il va de soi, et comme il résulte d'ailleurs déjà de ce qui précède, l'invention ne se limite nullement à ceux de ses modes d'application et de réalisation qui ont été plus particulièrement envisagés ; elle en embrasse, au contraire, toutes les variantes, notamment celle selon laquelle les sections offertes au passage du courant sont optimisées pour chacun des deux types N et P de thermo-éléments et pour les conditions de fonctionnement, cette optimisation se faisant en fonction des caractéristiques thermo-électriques de chacun des deux types N et P, le cas particulier où les sections sont égales pour les deux types de thermo-éléments correspondant à des caractéristiques thermo-électriques égales ou voisines pour ceux-ci.

**Revendications**

1. Module thermo-électrique composé de thermo-éléments et de conducteurs électriques et destiné à coopérer avec des échangeurs de chaleur pour constituer des installations thermo-électriques formées par des empilements de pièces actives thermo-électriques associées chacune à un échangeur de chaleur recevant un fluide à refroidir ou servant de source froide et à un échangeur de chaleur recevant un fluide à réchauffer ou servant de source chaude, caractérisé par le fait qu'il comporte un nombre impair $(2x+1)$ de thermo-éléments — $(x)$ étant un entier positif non nul — $(x+1)$ thermo-éléments étant d'un type N ou P et $(x)$ thermo-éléments étant de l'autre type P ou N, lesdits thermo-éléments étant placés électriquement en série et thermiquement en parallèle, et reliés par des moyens de connexion (3) à des conducteurs électriques eux-mêmes reliés à la face intérieure de deux pièces électriquement conductrices (8a, 8b) en contact électrique et thermique par leur face extérieure avec les échangeurs de chaleur (9, 9a, 9b, 9c) qui servent également d'amenées de courant, les conducteurs électriques liés aux thermo-éléments étant soit des conducteurs d'un premier type (4a, 4b) au nombre de deux reliés chacun à une face du thermo-élément d'entrée et du thermo-élément de sortie du courant et en contact thermique et électrique chacun avec une des pièces (8a, 8b), constituant ainsi l'entrée et la sortie du courant dans le module, soit des conducteurs d'un second type (6a, 6b, 6c, 6d, 6e, 6f, 6g, 6h, 6i, 6j) au nombre de $(2x)$ fixés en deux groupes de $(x)$ conducteurs respectivement sur chacune des faces intérieures des pièces (8a, 8b) et en contact thermique avec celles-ci mais isolés électriquement de ces pièces (8a, 8b) par au moins une couche (7, 10) déposée sur la face des conducteurs de second type en regard de la face intérieure des pièces (8a, 8b), les conducteurs de second type reliant deux à deux les faces des thermo-éléments qui ne sont pas les deux faces d'entrée et de sortie de courant liées elles aux deux conducteurs de premier type, créant ainsi un cheminement préférentiel du courant et l'obligeant à transiter à travers tous les thermo-éléments sans passer par les pièces (8a, 8b) entre l'entrée et la sortie du courant.

2. Module thermo-électrique selon la revendication 1, caractérisé par le fait que l'entrée et la sortie de courant dans le module se font par deux thermo-éléments du type auquel appartiennent les $(x+1)$ thermo-éléments, ce qui permet de créer deux types de modules fonctionnellement équivalents à des thermo-éléments uniques de type N et P.

3. Module selon la revendication 1 ou 2, caractérisé par le fait que la disposition des $(2x+1)$ thermo-éléments est réalisée selon une géométrie circulaire, les deux pièces (8a, 8b) assurant les contacts électriques et thermiques avec les échangeurs (9, 9a, 9b, 9c) ayant alors également une géométrie circulaire.

4. Module selon la revendication 1 ou 2, caractérisé par le fait que la disposition des $(2x+1)$ thermo-éléments est réalisée selon une géométrie rectangulaire ou carrée, les thermo-éléments étant disposés suivant un réseau en damier, les deux pièces (8a, 8b) assurant les contacts électriques et thermiques avec les échangeurs (9, 9a, 9b, 9c) ayant alors également une géométrie rectangulaire ou carrée.

5. Module selon la revendication 1 ou 2, caractérisée par le fait que la disposition de (2x+1) thermo-éléments est réalisée selon une géométrie telle que les deux pièces (8a, 8b) qui les recouvrent en assurant les contacts électriques et thermiques avec les échangeurs (9) aient alors une forme polygonale régulière ou non.

6. Module selon l'une quelconque des revendications 1 à 5, caractérisé par le fait que l'isolement électrique des conducteurs du second type (6a- 6j) d'avec les pièces (8a, 8b) est obtenu par une couche isolante mince (7) déposée sur la face des conducteurs (6a, -6j) en regard des pièces (8a, 8b), le contact thermique et la liaison mécanique avec les pièces (8a, 8b) étant assurés par une couche (10) qui peut être un adhésif ou une brasure impliquant, dans ce dernier cas, que la couche isolante (7) soit brasable grâce à un traitement de surface approprié.

7. Module selon l'une quelconque des revendications 1 à 5, caractérisé par le fait que l'isolement électrique des conducteurs (6a- 6j) d'avec les pièces (8a, 8b) est obtenu par une couche isolante mince (7) déposée sur les faces des conducteurs (6a-6j) en regard des pièces (8a, 8b), cette couche étant un adhésif qui assure le contact thermique et la liaison mécanique avec les pièces (8a, 8b).

8. Module selon l'une quelconque des revendications 1 à 7, caractérisé par le fait qu'au moins une des deux faces extérieures des pièces (8a, 8b) en contact thermique et électrique avec les échangeurs de chaleur (9, 9a, 9b, 9c) présente un profil non plan coopérant avec un profil conjugué ménagé dans la base du ou des échangeurs de chaleur correspondants.

9. Module selon la revendication 8, caractérisé par le fait que l'une des deux faces extérieures des pièces (8a, 8b) en contact thermique et électrique avec un échangeur de chaleur (9, 9a, 9b, 9c) est plane, l'autre face étant une portion de surface sphérique convexe ou concave, coopérant avec une surface sphérique conjuguée ménagée dans la base de l'autre échangeur de chaleur.

10. Module selon la revendication 8, caractérisé par le fait que les deux faces extérieures des pièces (8a, 8b) en contact thermique et électrique avec les échangeurs de chaleur (9, 9a, 9b, 9c) sont des portions de surface sphérique convexes ou concaves, coopérant avec des surfaces sphériques conjuguées ménagées dans les bases des susdits échangeurs de chaleur, les surfaces sphériques des pièces (8a, 8b) pouvant être toutes deux convexes ou concaves ou l'une convexe et l'autre concave.

11. Module selon la revendication 8, caractérisé par le fait que l'une des deux faces extérieures des pièces (8a, 8b) en contact thermique et électrique avec les échangeurs de chaleur (9, 9a, 9b, 9c) est plane, l'autre face étant une portion de surface cylindrique convexe ou concave à axe parallèle au plan de la surface plane, coopérant avec une surface cylindrique conjuguée ménagée dans la base de l'échangeur de chaleur correspondant.

12. Module selon la revendication 8, caractérisé par le fait que les deux faces extérieures des pièces (8a, 8b) en contact thermique et électrique avec les échangeurs de chaleur (9, 9a, 9b, 9c) sont des portions de surface cylindrique convexe ou concave à axes parallèles entre eux ou orthogonaux entre eux mais situés dans des plans parallèles entre eux, coopérant avec des portions de surface cylindrique conjuguées ménagées dans les bases des susdits échangeurs de chaleur, les surfaces cylindriques des pièces (8a, 8b) pouvant être toutes deux convexes ou concaves ou l'une convexe et l'autre concave et dans chaque cas leurs axes pouvant être parallèles ou orthogonaux.

13. Module selon l'une quelconque des revendications 1 à 12, caractérisé par le fait que les sections offertes au passage du courant sont optimisées pour chacun des deux types N et P de thermo-éléments et pour les conditions de fonctionnement, cette optimisation se faisant en fonction des caractéristiques thermo-électriques de chacun des deux types N et P.

14. Module selon la revendication 13 dans lequel les caractéristiques thermo-électriques des deux types N et P de thermo-éléments sont égales ou voisines, caractérisé par le fait que les sections offertes au passage du courant pour les deux types N et P des thermo-éléments sont égales.

15. Installation thermo-électrique constituée par des empilements d'échangeurs de chaleur, conducteurs de courant et de pièces actives thermo-électriques en contact thermique et électrique avec lesdits échangeurs, caractérisée par le fait que lesdites pièces actives sont constituées par des modules des deux types N et P selon l'une quelconque des revendications 1 à 14.

**Claims**

1. Thermoelectric module composed of thermoelements and electrical connectors and intended to co-operate with heat exchangers to constitute thermoelectric devices formed by stacks of active thermoelectric units each associated with a heat exchanger receiving a fluid to be cooled or serving as a cold source and a heat exchanger receiving a fluid to be heated or serving as a heat source, characterised by the fact that it comprises an odd number (2x+1) of thermoelements — (x) being a positive, non-zero integer — (x+1) thermoelements being of a N or P-type and (x) thermoelements being of the other P or N-type, said thermoelements being connected electrically in series and thermally in parallel and being secured by connection means (3) to electrical connectors themselves secured to the inner face of two electrically conducting members (8a, 8b) in electrical and thermal contact through their external face with the heat exchangers (9, 9a, 9b, 9c) which also serve for the supply of current, the electrical connectors which are secured to thermoelements being either two connectors of a first type (4a, 4b) each secured to a face of the thermoelement for the inlet and of the thermoelement for the outlet of current and each in thermal and electrical contact with one of the members (8a, 8b), thus constituting the module current inlet and outlet, or connectors of a second type (6a, 6b, 6c, 6d, 6e, 6f, 6g, 6h, 6i, 6j), which are (2x) in number, secured in two groups of (x) connectors respectively to each of the inner faces of the members (8a, 8b) and in thermal contact therewith but electrically insulated from these members (8a, 8b) by at least one layer (7, 10) disposed on the surface of the second type connectors facing the inner face of the members (8a, 8b), the connectors of the second type connecting two by two the faces of the thermoelements which are not the two current inlet and outlet faces themselves connected to the two connectors of the first type, thus creating a preferential path for the current and forcing it to flow through all the thermoelements without flowing through the members (8a, 8b) between the current inlet and outlet.

2. Thermoelectric module according to Claim 1, characterised by the fact that the current inlet and outlet in the module are formed by two thermoelements of the type to which the (x+1) thermoelements belong, which makes it possible to create two types of module functionally equivalent to single N and P-type thermoelements.

3. Module according to Claim 1 or 2, characterised by the fact that the arrangement of the (2x+1) thermoelements is of circular geometry, the two members (8a, 8b) ensuring the electrical and thermal contacts with the exchangers (9, 9a, 9b, 9c) thus also having circular geometry.

4. Module according to Claim 1 or 2, characterised by the fact that the arrangement of the (2x+1) thermoelements is of rectangular or square geometry, the thermoelements being disposed in a chessboard pattern, the two members (8a, 8b) ensuring the electrical and thermal contacts with the exchangers (9, 9a, 9b, 9c) thus also having rectangular or square geometry.

5. Module according to Claim 1 or 2, characterised by the fact that the arrangement of (2x+1) thermoelements is of geometry such that the two members (8a, 8b) which cover them ensuring the electrical and thermal contacts with the exchangers (9) thus have a regular or non-regular polygonal shape.

6. Module according to one of Claims 1 to 5, characterised by the fact that the electrical insulation between the connectors of the second type (6a-6j) and the members (8a, 8b) is provided by a thin insulating layer (7) disposed on the face of the connectors (6a-6j) facing the members (8a, 8b), the thermal contact and mechanical connection to the members (8a, 8b) being ensured by a layer (10) which may be an adhesive or solder implying, in the latter case, that the insulating layer (7) can be soldered by a suitable surface treatment.

7. Module according to one of Claims 1 to 5, characterised by the fact that the electrical insulation between the connectors (6a-6j) and the members (8a, 8b) is provided by a thin insulating layer (7) disposed on the faces of the connectors (6a-6j) facing the members (8a, 8b), this layer being an adhesive which ensures the thermal contact and mechanical connection with the members (8a, 8b).

8. Module according to one of Claims 1 to 7, characterised by the fact that at least one of the two external faces of the members (8a, 8b) in thermal and electrical contact with the heat exchangers (9, 9a, 9b, 9c) has a non-planar profile co-operating with a matching profile provided in the base of the corresponding heat exchanger or exchangers.

9. Module according to Claim 8, characterised by the fact that one of the two external faces of the members (8a, 8b) in thermal and electrical contact with a heat exchanger (9, 9a, 9b, 9c) is planar, the other face being a portion of convex or concave spherical surface, co-operating with a matching spherical surface provided in the base of the other heat exchanger.

10. Module according to Claim 8, characterised by the fact that the two external faces of the members (8a, 8b) in thermal and electrical contact with the heat exchangers (9, 9a, 9b, 9c) are portions of convex of concave spherical surface, co-operating with matching spherical surfaces provided in the bases of the said heat exchangers, the spherical surfaces of the members (8a, 8b) being able to be both convex or concave or one convex and the other concave.

11. Module according to Claim 8, characterised by the fact that one of the two external faces of the members (8a, 8b) in thermal and electrical contact with the heat exchangers (9, 9a, 9b, 9c) is planar, the other face being a portion of convex or concave cylindrical surface having an axis parallel to the plane of the planar surface, co-operating with a matching cylindrical surface provided in the base of the corresponding heat exchanger.

12. Module according to Claim 8, characterised by the fact that the two external faces of the members (8a, 8b) in thermal and electrical contact with the heat exchangers (9, 9a, 9b, 9c) are portions of convex or concave cylindrical surface with axes either parallel or orthogonal but situated in parallel planes co-operating with matching portions of cylindrical surface provided in the bases of said heat exchangers, the cylindrical surfaces of the members (8a, 8b) being able to be both convex or concave or one convex and the other concave and in each case their axes being able to be parallel or orthogonal.

13. Module according to one of Claims 1 to 12, characterised by the fact that the cross-sections provided for current flow are optimized for each of the two N and P-types of thermoelements and for the operating conditions, this optimization being carried out according to the thermoelectric characteristics of each of the two N and P-types.

14. Module according to Claim 13, in which the thermoelectric characteristics of the two N and P-types of thermoelements are equal or similar, characterised by the fact that the cross-sections provided for the passage of current for the two N and P-types of thermoelements are equal.

15. Thermoelectric device constituted by stacks of electrically conducting heat exchangers and active thermoelectric members in thermal and electrical contact with the said exchangers, characterised by the fact that the said active members are constituted by modules of the two N and P-types according to one of Claims 1 to 14.

## Patentansprüche

1. Thermoelektrisches Modul, bestehend aus Thermoelementen und elektrischen Leitern, für die Zusammenwirkung mit Wärmetauschern zur Bildung von thermoelektrischen Einrichtungen, die aus Stapeln von aktiven thermoelektrischen Teilen bestehen, von denen jedes mit einem Wärmetauscher, der ein Kühlmittel aufnimmt oder als kalte Quelle dient, und mit einem Wärmetauscher, der ein Erwärmungsmittel aufnimmt oder als heiße Quelle dient, verbunden ist, dadurch gekennzeichnet, daß es eine ungerade Anzahl (2x+1) von Thermoelementen enthält — wobei (x) eine positive ganze Zahl ungleich Null ist und (x+1) Thermoelemente vom Typ N oder P und (x) Thermoelemente vom jeweils anderen Typ P oder N sind, wobei die Thermoelemente elektrisch in Serie und thermisch parallel angeordnet und durch Verbindungseinrichtungen (3) mit elektrischen Leitern verbunden sind, die selbst wiederum mit der Innenfläche von zwei elektrisch leitenden Teilen (8a, 8b) verbunden sind, die über ihre Außenfläche in elektrischem und thermischem Kontakt mit den Wärmetauschern (9, 9a, 9b, 9c) stehen, die gleichzeitig als Stromzuführungen dienen, wobei die mit den Thermoelementen verbundenen elektrischen Leiter entweder Leiter eines ersten Typus (4a, 4b) in einer Anzahl von zwei sind, die jeweils mit einer Fläche des Stromeingangs-Thermoelementes und des Stromausgangs-Thermoelementes in Verbindung stehen und in thermischem und elektrischem Kontakt jeweils mit einem der Teile (8a, 8b) stehen und dadurch den Eingang und den Ausgang für den Strom in dem Modul bilden, oder Leiter eines zweiten Typus (6a, 6b, 6c, 6d, 6e, 6f, 6g, 6h, 6i, 6j) in einer Anzahl von (2x) sind, die in zwei Gruppen von (x) Leitern jeweils an den Innenflächen der Teile (8a, 8b) befestigt sind und in thermischem Kontakt mit diesen stehen, aber dennoch von diesen Teilen (8a, 8b) elektrisch isoliert sind durch wenigstens eine Schicht (7, 10), die auf derjenigen Fläche der Leiter des zweiten Typus aufgebracht ist, die der Innenfläche der Teile (8a, 8b) zugewandt ist, wobei die Leiter des zweiten Typus jeweils in Zweiereinheiten diejenigen Flächen der Thermoelemente miteinander verbinden, die nicht die zwei Strom-Eingangs- und Ausgangsflächen sind, die wiederum selbst mit zwei Leitern des ersten Typus verbunden sind, wodurch ein bevorzugter Stromweg erzeugt wird und der Strom zwangsweise durch alle Thermoelemente hindurchfließt, ohne durch die Teile (8a, 8b) zwischen dem Eingang und dem Ausgang des Stromes hindurchzutreten.

2. Thermoelektrisches Modul nach Anspruch 1, dadurch gekennzeichnet, daß Stromeingang und Stromausgang in dem Modul durch zwei Thermoelemente desjenigen Typus erfolgen, zu dem die (x+1) Thermoelemente gehören, wodurch es möglich wird, zwei Typen von Modulen zu schaffen, die funktionell äquivalent entweder zu Thermoelementen allein des Typs N oder des Typs P sind.

3. Modul nach Anspruch 1 oder 2, dadurch gekennzeichnet, daß die (2x+1) Thermoelemente kreisförmig angeordnet sind und daß die zwei Teile (8a, 8b) den elektrischen und thermischen Kontakt mit den Austauschern (9, 9a, 9b, 9c), die dann ebenfalls kreisförmig ausgebildet sind, gewährleisten.

4. Modul nach Anspruch 1 oder 2, dadurch gekennzeichnet, daß die (2x+1) Thermoelemente rechteckig oder quadratisch ausgebildet und schachbrettmusterartig angeordnet sind und daß die zwei Teile (8a, 8b) den elektrischen und thermischen Kontakt mit den Austauschern (9, 9a, 9b, 9c), die gleichfalls rechteckig oder quadratisch ausgebildet sind, gewährleisten.

5. Modul nach Anspruch 1 oder 2, dadurch gekennzeichnet, daß die (2x+1) Thermoelemente dergestalt angeordnet sind, daß die zwei Teile (8a, 8b), die sie bedecken und dadurch den elektrischen und thermischen Kontakt mit den Austauschern (9) gewährleisten, dann eine gleichmäßige polygonale Form oder auch nicht aufweisen.

6. Modul nach einem der Ansprüche 1 bis 5, dadurch gekennzeichnet, daß die elektrische Isolierung der Leiter des zweiten Typus (6a-6j) von den Teilen (8a, 8b) durch eine dünne Isolierschicht (7) erfolgt, die auf der den Teilen (8a, 8b) zugewandten Fläche der Leiter (6a-6j) aufgebracht ist, und daß der thermische Kontakt und die mechanische Verbindung mit den Teilen (8a, 8b) durch eine Schicht (10) gewährleistet wird, die eine Klebefläche oder eine Lötfläche sein kann, wobei im letzteren Falle die Isolierschicht (7) aufgrund einer geeigneten Oberflächenbehandlung lötbar sein muß.

7. Modul nach einem der Ansprüche 1 bis 5, dadurch gekennzeichnet, daß die elektrische Isolierung der Leiter (6a-6j) von den Teilen (8a, 8b) durch eine dünne Isolierschicht (7) erfolgt, die auf der den Teilen (8a, 8b) zugewandten Fläche der Leiter (6a-6j) aufgebracht ist und eine Klebefläche darstellt, die den thermischen Kontakt und die mechanische Verbindung mit den Teilen (8a, 8b) gewährleistet.

8. Modul nach einem der Ansprüche 1 bis 7, dadurch gekennzeichnet, daß wenigstens eine der beiden Außenflächen der Teile (8a, 8b), die in thermischem und elektrischem Kontakt mit den Wärmetauschern (9, 9a, 9b, 9c) stehen, ein nicht ebenes Profil aufweist, das mit einem komplementären Profil zusammenwirkt, das in dem Basisteil des oder der entsprechenden Wärmetauscher ausgebildet ist.

9. Modul nach Anspruch 8, dadurch gekennzeichnet, daß eine der beiden Außenflächen der in thermischem und elektrischem Kontakt mit einem Wärmetauscher (9, 9a, 9b, 9c) stehenden Teile (8a, 8b) eben ist, und daß die andere Fläche eine konvexe oder konkave sphärische Oberfläche ist, die mit einer komplementären sphärischen Oberfläche zusammenwirkt, die in dem Basisteil des anderen Wärmetauschers ausgebildet ist.

10. Modul nach Anspruch 8, dadurch gekennzeichnet, daß die beiden Außenflächen der in thermischem und elektrischem Kontakt mit den Wärmetauschern (9, 9a, 9b, 9c) stehenden Teile (8a, 8b) konvexe oder konkave sphärische Oberflächen sind, die mit komplementären sphärischen Oberflächen zusammenwirken, die in den Basisteilen der oben genannten Wärmetauscher ausgebildet sind, wobei die sphärischen Oberflächen der Teile (8a, 8b) entweder alle beide konvex oder konkav, oder aber die eine konvex und die andere konkav sein können.

11. Modul nach Anspruch 8, dadurch gekennzeichnet, daß die eine der beiden Außenflächen der mit den Wärmetauschern (9, 9a, 9b, 9c) in thermischem und elektrischem Kontakt stehenden Teile (8a, 8b) eben ist, und die andere Fläche eine zur Ebene der ebenen Oberfläche achsparallele, konvexe oder konkave zylindrische Oberfläche ist, die mit einer komplementären zylindrischen Oberfläche zusammenwirkt, die in dem Basisteil des entsprechenden Wärmetauschers ausgebildet ist.

12. Modul nach Anspruch 8, dadurch gekennzeichnet, daß die beiden Außenflächen der in thermischem und elektrischem Kontakt mit den Wärmetauschern (9, 9a, 9b, 9c) stehenden Teile (8a, 8b) konvexe oder konkave zylindrische Oberflächen sind, die achsparallel oder senkrecht zueinander angeordnet sind, aber in zueinander parallelen Ebenen gelegen sind und mit komplementären zylindrischen Oberflächen, die in den Basisteilen der oben genannten Wärmetauscher ausgebildet sind, zusammenwirken, wobei die zylindrischen Oberflächen der Teile (8a, 8b) entweder alle beide konvex oder konkav, oder die eine konvex und die andere konkav sein können und ihre Achsen in jedem Falle parallel oder senkrecht zueinander sein können.

13. Modul nach einem der Ansprüche 1 bis 12, dadurch gekennzeichnet, daß die für den Stromdurchfluß vorgesehenen Querschnitte für jeden der beiden Thermoelement-Typen N und P und entsprechend den Betriebsbedingungen optimiert sind und daß die Optimierung in Abhängigkeit von den thermoelektrischen Eigenschaften jedes der beiden Typen N und P erfolgt.

14. Modul nach Anspruch 13, in dem die thermoelektrischen Eigenschaften der beiden Thermoelement-Typen N und P gleich oder nahezu gleich sind, dadurch gekennzeichnet, daß die für den Stromdurchfluß vorgesehenen Querschnitte für die beiden Thermoelement-Typen N und P gleich sind.

15. Thermoelektrische Einrichtung, bestehend aus Stapeln von stromleitenden Wärmetauschern und aktiven thermoelektrischen Teilen in thermischem und elektrischem Kontakt mit den Wärmetauschern, dadurch gekennzeichnet, daß die aktiven Teile durch Module der beiden Typen N und P nach einem der Ansprüche 1 bis 14 gebildet werden.

# FIG.1.

# FIG.2.

FIG.3.

FIG. 4 .

FIG.5.

FIG.6.

FIG.9.

FIG.10.

FIG.11.

FIG. 7.

FIG.8.

EP 0 176 671 B1